(19) Europäisches Patentamt
European Patent Office
Office européen des brevets

(11) EP 1 614 537 B1

(12) EUROPEAN PATENT SPECIFICATION

(45) Date of publication and mention of the grant of the patent:
**17.10.2007 Bulletin 2007/42**

(21) Application number: **05014746.1**

(22) Date of filing: **07.07.2005**

(51) Int Cl.:
***B41C 1/10*** *(2006.01)* ***G03F 7/00*** *(2006.01)*

# (54) Lithographic printing plate precursor and lithographic printing method

Flachdruckplattenvorläufer und lithographisches Druckverfahren

Précurseur de plaque d'impression lithographique et méthode d'impression lithographique

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.07.2004 JP 2004200540**

(43) Date of publication of application:
**11.01.2006 Bulletin 2006/02**

(73) Proprietor: **FUJIFILM Corporation**
**Minato-ku**
**Tokyo (JP)**

(72) Inventors:
- **Aoshima, Norio**
  **Yoshida-cho**
  **Haibara-gun**
  **Shizuoka (JP)**
- **Yamasaki, Sumiaki**
  **Yoshida-cho**
  **Haibara-gun**
  **Shizuoka (JP)**

(74) Representative: **HOFFMANN EITLE**
**Patent- und Rechtsanwälte**
**Arabellastrasse 4**
**81925 München (DE)**

(56) References cited:
**EP-A- 1 338 435** **US-B1- 6 258 510**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 614 537 B1

## Description

### FIELD OF THE INVENTION

The present invention relates to an on-press developable lithographic printing plate precursor and a lithographic printing method using the lithographic printing plate precursor.

### BACKGROUND OF THE INVENTION

The lithographic printing plate in general consists of a lipophilic image area of receiving an ink in the printing process and a hydrophilic non-image area of receiving a fountain solution. The lithographic printing is a printing method utilizing the repellency between water and oily ink from each other, where the lipophilic image area of the lithographic printing plate and the hydrophilic non-image area are formed as an ink-receiving part and a fountain solution-receiving part (ink non-receiving part), respectively, to cause difference in the ink adhesion on the surface of the lithographic printing plate, an ink is attached only to the image area and thereafter, the ink is transferred to a material on which the image is printed, such as paper, thereby performing printing.

For producing this lithographic printing plate, a lithographic printing plate precursor (PS plate) comprising a hydrophilic support having provided thereon a lipophilic photosensitive resin layer (image recording layer) has been heretofore widely used. Usually, a lithographic printing plate is obtained by a plate-making method where the lithographic printing plate precursor is exposed through an original image such as lith film and while leaving the image-recording layer working out to the image area, the other unnecessary image-recording layer is dissolved and removed with an alkaline developer or an organic solvent to reveal the hydrophilic support surface, thereby forming a non-image area.

In the plate-making process using a conventional lithographic printing plate precursor, a .step of dissolving and removing the unnecessary image recording layer with a developer or the like must be provided after exposure but as one problem to be solved, it is demanded to dispense with or simplify such an additive wet processing. In particular, the treatment of waste solutions discharged accompanying the wet processing is recently a great concern to the entire industry in view of consideration for global environment and the demand for solving the above-described problem is becoming stronger.

As one of simple plate-making methods to cope with such a requirement, a method called on-press development has been proposed, where an image recording layer allowing for removal of the unnecessary portion of the image recording layer in a normal printing process is used and after exposure, the unnecessary portion of the image recording layer is removed on a printing press to obtain a lithographic printing plate.

Specific examples of the on-press development method include a method using a lithographic printing plate precursor having an image recording layer dissolvable or dispersible in a fountain solution, an ink solvent or an emulsified product of fountain solution and ink, a method of mechanically removing the image recording layer by the contact with rollers or a blanket cylinder of a printing press, and a method of weakening the cohesion of the image recording layer or adhesion between the image recording layer and the support by the impregnation of a fountain solution, an ink solvent or the like and then mechanically removing the image recording layer by the contact with rollers or a blanket cylinder.

In the present invention, unless otherwise indicated, the "development processing step" indicates a step where, by using an apparatus (usually an automatic developing machine) except for a printing press, the image recording layer unexposed with an infrared laser of a printing plate precursor is removed through contact with a liquid (usually an alkaline developer) to reveal the hydrophilic support surface, and the "on-press development" indicates a method or step where, by using a printing press, the image recording layer unexposed with an infrared laser is removed through contact with a liquid (usually a printing ink and/or a fountain solution) to reveal the hydrophilic support surface.

However, when an image recording layer for conventional image recording systems utilizing ultraviolet ray or visible light is used, the image recording layer is not fixed after exposure and therefore, for example, a cumbersome method of storing the exposed lithographic printing plate precursor in a completely light-shielded state or under constant temperature conditions until loading on a printing press must be taken.

On the other hand, a digitization technique of electronically processing, storing and outputting image information by using a computer has been...recently widespread and various new image-output systems coping with such a digitization technique have been put into practical use. Along with this, a computer-to-plate technique is attracting attention, where digitized image information is carried on a highly converging radiant ray such as laser light and a lithographic printing plate precursor is scan-exposed by this light to directly produce a lithographic printing plate without intervention of a lith film. Accordingly, one of important technical problems to be solved is to obtain a lithographic printing plate precursor suitable for such a technique.

As described above, the demand for a simplified, dry-system or non-processing plate-making work is ever-stronger in recent years from both aspects of consideration for global environment and adaptation for digitization, and studies to meet this requirement are being made.

For example, Japanese Patent No. 2,938,397 describes a lithographic printing plate precursor where an image forming layer comprising a hydrophilic binder having dispersed therein hydrophobic thermoplastic polymer particles is provided on a hydrophilic support. In Japanese Patent No. 2,938,397, it is stated that after this lithographic printing plate precursor is exposed with an infrared laser to cause thermal coalescence of hydrophobic thermoplastic polymer particles and thereby form an image and then loaded on a cylinder of a printing press, the printing plate precursor can be on-press developed by supplying a fountain solution and/or ink.

However, such a method of forming an image through coalescence by mere heat fusion of fine particles has a problem that despite good on-press developability, the image strength (adhesion to the support) is extremely low and the press life is not satisfied.

For solving these problems, a technique of improving the press life by utilizing a polymerization reaction has been studied. For example, JP-A-2001-277740 and JP-A-2001-277742 describe a lithographic printing plate precursor comprising a hydrophilic support having thereon a layer containing a polymerizable compound-enclosing microcapsule.

Also, JP-A-2002-287334 describes a lithographic printing plate precursor comprising a support having provided thereon a photosensitive layer containing an infrared absorbent, a radical polymerization initiator and a polymerizable compound.

Furthermore, JP-A-2000-39711 describes a lithographic printing plate precursor which can be on-press developed after exposure, the printing plate precursor comprising an aluminum support having thereon a layer comprising a photosensitive composition containing (a) a water-soluble or water-dispersible polymer, (b) a monomer or oligomer having a photopolymerizable ethylenically unsaturated double bond and (c) a photopolymerization initiation system having absorption maximum in the ultraviolet region.

## SUMMARY OF THE INVENTION

In this way, the press life of on-press developable lithographic printing plate precursors is improved by utilizing a polymerization reaction. Furthermore, the on-press developability with a printing ink and the inking property can be enhanced by using a hydrophobic polymer binder as the polymer binder. However, in practice, there arises a new problem that the substance removed by the on-press development deposits as a debris on an ink roller and a trouble is caused in the printing work.

The present invention has been made to solve such a problem. That is, an object of the present invention is to provide a lithographic printing plate precursor which can be on-press developed after exposure, give a good printed matter free of staining and be prevented from attachment of the removed image recording layer to an ink roller.

As a result of intensive studies on the process of the unexposed area of the image recording layer being dispersed in an ink during on-press development, the present inventors have found that the adhesion of a substance removed by the on-press development to an ink roller is related with the elastic modulus of a film made by a polymerizable compound and a polymer binder which are main components of the image recording layer, and when this elastic modulus is set to a specific value, the adhesion of a removed substance to an ink roller is greatly decreased. The present invention is based on this finding.

That is, the present invention is as defined in the claims. .

The operational effect of the present invention is not clearly known but is presumed as follows. A substance removed by the on-press development is dispersed in an ink and fined down by the force of a roller kneading the ink, and the elastic modulus affects this fining down. More specifically, when the elastic modulus is large and the removed substance has a high film strength, fining down does not proceed and the removed film deposits as a debris. On the other hand, in the case of a weak film having an elastic modulus of 294.2 KPa (30 g/mm$^2$) or less, fining down proceeds and the removed film is successfully dispersed in the ink and discharged to a printing paper sheet, as a result, deposition of a debris does not occur.

According to the present invention, a lithographic printing plate precursor capable of being on-press developed after exposure, giving a good printed matter free of staining, and being prevented from attachment of the removed image recording layer to an ink roller can be provided.

## DETAILED DESCRIPTION OF THE INVENTION

[Image Recording Layer]

The image recording layer of the present invention comprises (A) a polymerization initiator, (B) at least one polymerizable compound having at least one ethylenically unsaturated double bond, and (C) a polymer binder selected

from copolymers of acrylic esters and/or methacrylic esters, and can be removed with a printing ink and/or a fountain solution. Moreover, if a film is made by the polymerizable compound (B) and the polymer binder (C) contained in the image recording layer, the film has an elastic modulus of 294.2 KPa 30 g/mm$^2$ or less.

The elastic modulus is determined from the gradient in the rising linear portion of a stress-strain curve obtained by measuring the stress-strain relationship with use of a tensile tester (Tensilon Tester Model UTM-II-20, manufactured by Orientec Corp.). The sample used for the measurement of elastic modulus is produced as follows.

A solution comprising only the polymerizable compound and the polymer binder in the composition of the coating solution for the image recording layer is spread on a Teflon sheet and dried under heating. At this time, the concentration of the solution is adjusted to give a dry film thickness of approximately from 0.2 to 1.0 mm. The film obtained after drying is cut into a size of 10 mm x 50 mm and measured with a gripping distance of 30 mm. The measurement is performed 5 times and the average thereof is employed. The thickness, width and length of the sample film are precisely measured by using a vernier calipers or a micrometer, and the elastic modulus is calculated according to the following formula:

$$\text{Elastic modulus } (g/mm^2) = [\text{tensile load } (g)/\text{cross-sectional area of sample } (mm^2)]/\text{strain amount}$$

In the present invention, the elastic modulus of the film is preferably smaller, more preferably 147.1 KPa (15 g/mm$^2$) or less.

Furthermore, it has been found that, when the polymerizable compound and the polymer binder to be used in the image recording layer are selected to meet the requirement that the elastic modulus of the film made by the polymerizable compound and the polymer binder is 294.2 KPa (30 g/mm$^2$) or less, the size of the unexposed area of the image recording layer contained in the ink on an ink roller adjacent to an inking roller can also be reduced at the printing and in turn, the debris of the removed image recording layer can be prevented from depositing on the ink roller. That is, there is a relationship between the elastic modulus of the sample film (model film) in the image recording layer and the size of the unexposed area of the image recording layer in the ink on an ink roller.

Here, the size of the unexposed area of the image recording layer contained in the ink on an ink roller can be measured, for example, as follows.

A printing ink and/or a fountain solution are supplied to an exposed lithographic printing plate precursor to effect on-press development and when an inking roller is rotated 100 turns after the supply of a printing ink and/or a fountain solution, the ink on an ink roller adjacent to the inking roller is sampled, spread on a slide glass and measured on the maximum width by using a microscope. More specifically, 10 larger sizes in the observation range are selected, a largest size is excluded to eliminate a singular point, and the average of maximum widths of remaining 9 sizes is defined as the unexposed area size. In the measurement, when a transparent ink is used, the observation is facilitated and exact measurement can be performed.

Considering the case where the printing operation is continued over a long period of time, the thus-measured unexposed area size of the image recording layer in the ink is preferably smaller. For example, under the above-described measurement conditions, the unexposed area size is preferably 50 μm or less, more preferably 30 μm or less.

The components of the image recording layer are described below.

<Polymerization Initiator>

The polymerization initiator usable in the present invention is a compound of generating a radical by the effect of either one or both of light and heat energies and thereby initiating or accelerating the polymerization of a compound having a polymerizable unsaturated group. As for the polymerization initiator usable in the present invention, known thermopolymerization initiators, compounds having a bond with small bond-dissociation energy, photopolymerization initiators and the like may be used.

Examples of such a polymerization initiator include organohalogen compounds, carbonyl compounds, organoperoxides, azo-based compounds, azide compounds, metallocene compounds, hexaarylbiimidazole compounds, organoboron compounds, disulfone compounds, oxime ester compounds and onium salt compounds.

Specific examples of the organohalogen compound include the compounds described in Wakabayashi et al., Bull. Chem. Soc. Japan, 42, 2924 (1969), U.S. Patent 3,905,815, JP-B-46-4605 (the term "JP-B" as used herein means an "examined Japanese patent publication"), JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, M.P. Hutt, Journal of Heterocyclic Chemistry, 1, No. 3 (1970). Among these, oxazole compounds substituted with a trihalomethyl group

and S-triazine compounds are preferred.

Furthermore, s-triazine derivatives having at least one mono-, di- or tri-halogenated methyl group bonded to the s-triazine ring are more preferred and specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2- (α,α,β-trichloroethyl)-4,6-bis(trichloromethyl)-s-triazine, 2-phenyl-4,6-bis (trichloromethyl)-s-triazine, 2-(p-methoxyphenyl)-4,6-bis(triohloromethyl)-s-triazine, 2-(3,4-epoxyphenyl)-4,6-bis (trichloromethyl)-s-triazine, 2-(p-chlorophenyl)-4,6-bis(trichloromethyl)-s-triazine, 2-[1-(p-methoxyphenyl)-2,4-butadienyl]-4,6-bis(trichloxomethyl)-s-txiazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl,)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine and 2-methoxy-4,6-bis(tribromomethyl)-s-triazine.

Examples of the carbonyl compound include benzophenone derivatives such as benzophenone, Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1-hydroxycyclohexylphenylketone, α-hydroxy-2-methylphenylpropanone, 1-hydroxy-1-methylethyl-(p-isopropylphenyl) ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxanthone derivatives such as thioxanthone, 2-ethylthioxanthone, 2-isopropylthioxanthone, 2-chlorothioxanthone, 2,4-dimethylthioxanthone, 2,4-diethylthioxanthone and 2,4-diisopropylthioxanthone; and benzoic acid ester derivatives such as ethyl p-dimethylaminobenzoate and ethyl p-diethylaminobenzoate.

Examples of the azo-based compound which can be used include azo compounds described in JP-A-8-108621.

Examples of the organoperoxide include trimethylcyclohexanone peroxide, acetylacetdne peroxide, 1,1-bis (tertbutylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di (tert-butylperoxy)hexane, 2,5-oxanoyl peroxide, succinic peroxide, benzoyl peroxide, 2,4-dichlorobenzoyl peroxide, diisopropylperoxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butylperoxyacetate, tert-butylperoxypivalate, tert-butylperoxyneodecanoate, tert-butylperoxyoctanoate, tert-butylperoxylaurate, tert-carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogendiphthalate) and carbonyl di(tert-hexylperoxydihydrogendiphthalate) .

Examples of the metallocene compound include various titanocene compounds described in JP-A-59-152396, JP-A-61-151197, JP-A-63-41484, JP-A-2-249, JP-A-2-4705 and JP-A-5-83588, such as dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylayclopentadienyl-Ti--bis-2,6-difluorophen-1-yl, dimethylcyclopentadienyl-Ti-bis-2,4,6-trifluorophen-1-yl, dimethylayclopentadienyl-Ti-bis-2,3,5,6-tetrafluorophen-1-yl and dimethylcyclopentadienyl-Ti-bis-2,3,4,5,6-pentafluorophen-1-yl, and iron-allene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tetraphenylbiimidazole, 2,2'-bis(o-bromophenyl)-4,4',5,5'-tetraphenylbiimidazale, 2,2'-bis(o,p-dichlorophenyl)-4,4',5,5'-tetraphenylbiimidazole, 2,2'-bis(o-chlorophenyl)-4,4-,5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of the organoboron compound include organoborates described in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Martin Kunz, Rad Tech '98. Proceeding April 19-22, 1998, Chicago; organoboron sulfonium complexes and organoboron oxosulfonium complexes described in JP-A-6-157623, JP-A-6-175564 and JP-A-6-175561; organoboron iodonium complexes described in JP-A-6-175554 and JP-A-6-175553; organoboron phosphonium complexes described in JP-A-9-188710; and organoboron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin II, 1653-1660 (1979), J.C.S. Perkin II, 156-162 (1979), Journal of Photopolymer Science and Technology, 202-232 (1995), JP-A-2000-66385 and JP-A-2000-80068. Specific examples thereof include the compounds represented by the following structural formulae.

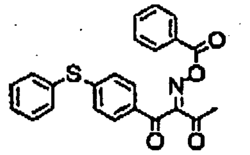 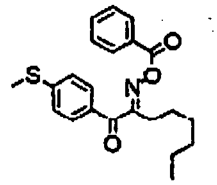 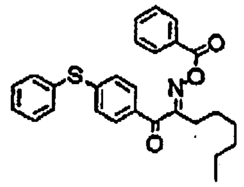 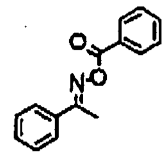 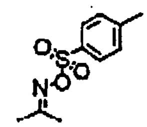

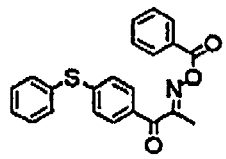 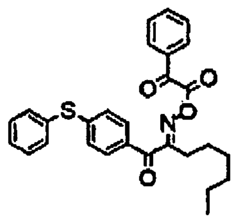 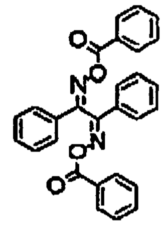 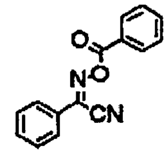 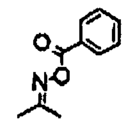

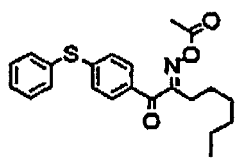 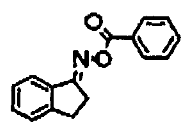 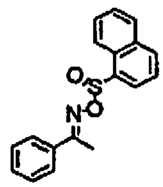 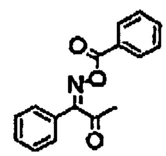 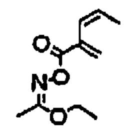

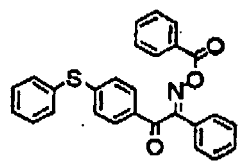 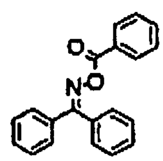 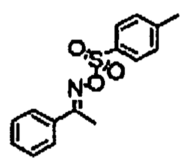 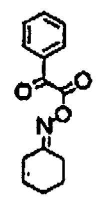 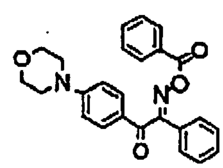

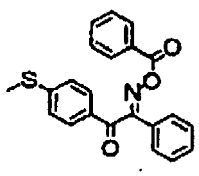 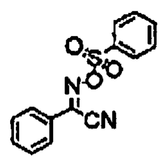

Examples of the onium salt compound include onium salts such as diazonium salts described in S.I. Schlesinger, Photogr. Sci. Eng., 18, 387 (1974) and T.S. Bal et al., Polymer, 21, 423 (1980); ammonium salts described in U.S. Patent 4,069,055 and JP-A-4-365049; phosphonium salts described in U.S. Patents 4,069,055 and 4,069,056; iodonium salts described in European Patent 104,143, U.S. Patents 339,049 and 410,201, JP-A-2-150848 and JP-A-2-296514; sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581; selenonium salts described in J.V. Crivello et al., Macromolecules, 10 (6), 1307 (1977) and J.V. Crivello et al., J. Polymer Sci., Polymer Chem. Ed., 17, 1047 (1979); and arsonium salts described in C.S. Wen et al., Teh. Proc. Conf. Rad. Curinq ASIA, page 478 (Tokyo, Oct. 1988).

Among these, oxime ester compounds and onium salts (diazonium salts, iodonium salts and sulfonium salts) are preferred in view of reactivity and stability. In the present invention, such an onium salt functions not as an acid generator but as an ionic radical polymerization initiator.

The onium salt which is suitably used in the present invention is an onium salt represented by any one of the following formulae (RI-I) to (RI-III):

$$Ar_{11}-\overset{+}{N}\equiv N \qquad Z_{11}^{-} \qquad \textbf{(RI-I)}$$

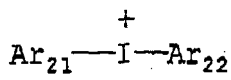 $Z_{21}^-$ (RI-II)

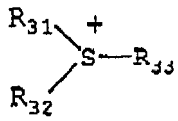 $Z_{31}^-$ (RI-III)

In formula (RI-I), $Ar_{11}$ represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamide or arylamide group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. $Z_{11}^-$ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, perchlorate ion, hexafluorophosphate ion, tetrafluoroborate ion, sulfonate ion and sulfinate ion are preferred in view of stability.

In formula (RI-II) , $Ar_{21}$ and $Ar_{22}$ each independently represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. $Z_{21}^-$ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, perchlorate ion, hexafluorophosphate ion, tetrafluoroborate ion, sulfonate ion, sulfinate ion and carboxylate ion are preferred in view of stability and reactivity.

In formula (RI-III), $R_{31}$, $R_{32}$ and $R_{33}$ each independently represents an aryl, alkyl, alkenyl or alkynyl group having 20 or less carbon atoms, which may have from 1 to 6 substituent(s), and in view of reactivity and stability, preferably represents an aryl group. Examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. $Z_{31}^-$ represents a monovalent anion and specific examples thereof include halogen ion, perchlorate ion, hexafluorophosphate ion, tetrafluoroborate ion, sulfonate ion, sulfinate ion, thiosulfonate ion, sulfate ion and carboxylate ion. Among these, preferred in view of stability and reactivity are perchlorate ion, hexafluorophosphate ion, tetrafluoroborate ion, sulfonate ion, sulfinate ion and carboxylate ion, more preferred is carboxylate ion described in JP-A-2001-343742, still more preferred is carboxylate ion described in JP-A-2002-148790.

Specific examples of the onium salt compound suitable for the present invention are set forth below, but the present invention is not limited thereto.

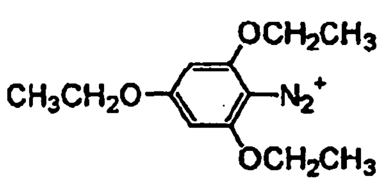 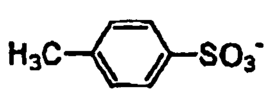 (N-1)

$PF^-_6$ (N-2)

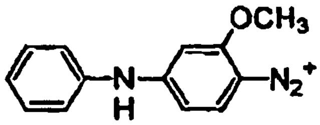

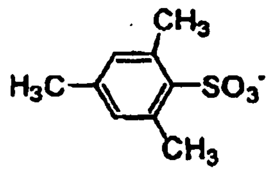

(N-3)

$ClO^-_4$ (N-4)

$PF^-_6$ (N-5)

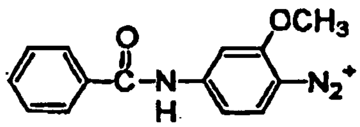

$CF_3SO_3^-$ (N-6)

$BF^-_4$ (N-7)

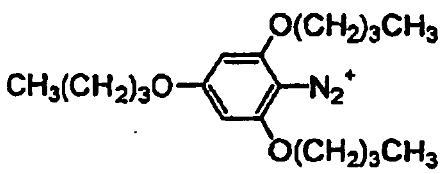

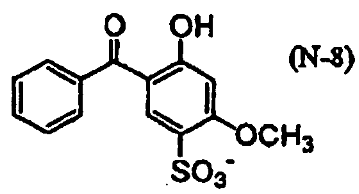

(N-8)

$ClO^-_4$ (N-9)

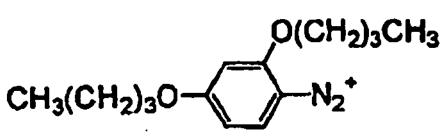

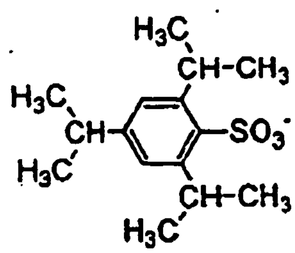

(N-10)

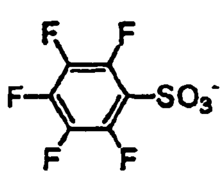

(N-11)

$PF^-_6$ (N-12)

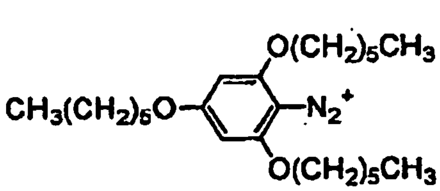 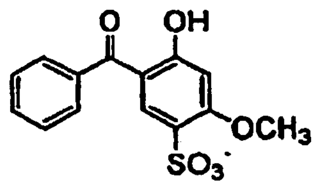 (N-13)

$ClO^-_4$ (N-14)

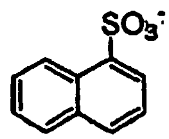 (N-15)

$PF^-_6$ (N-16)

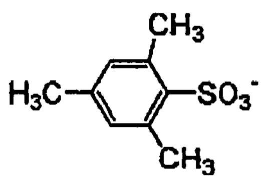 (N-17)

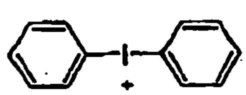 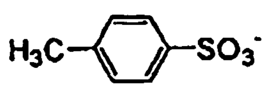 (I-1)

$PF^-_6$ (I-2)

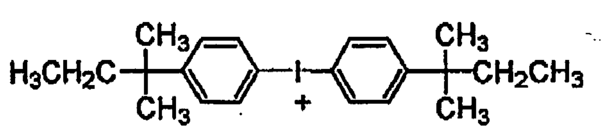

$PF^-_6$ (I-3)

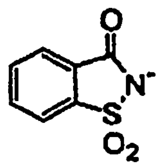

(I-9)

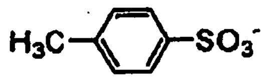

(I-4)

$ClO^-_4$ (I-5)

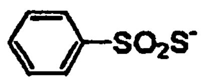

(I-10)

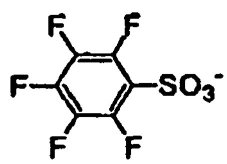

(I-6)

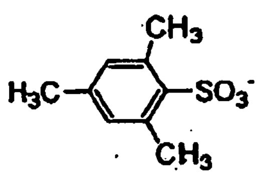

(I-11)

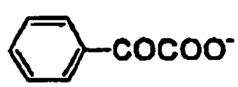

(I-7)

$CF_3SO^-3$ (I-8)

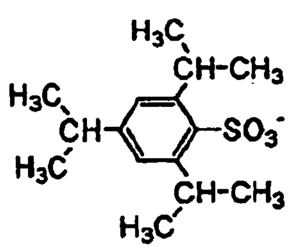

(I-12)

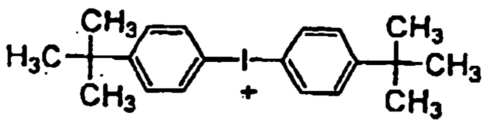 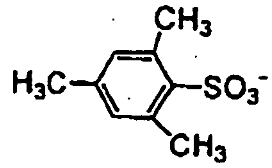 (I-13)

$ClO^-_4$ (I-14)

$PF^-_6$ (I-15)

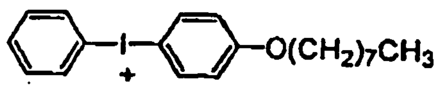 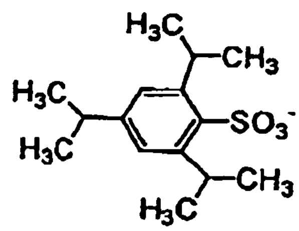 (I-16)

$CF_3COO^-$ (I-17)

$CF_3SO^-3$ (I-18)

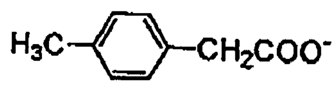 (I-19)

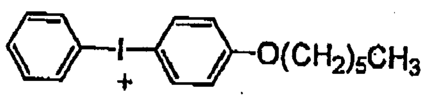 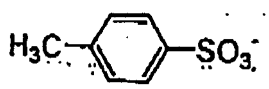 (I-20)

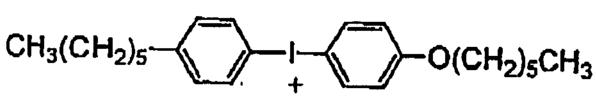 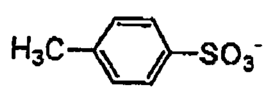 (I-21)

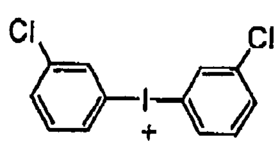

$BF_4^-$ (I-22)

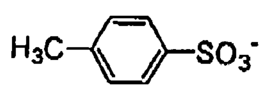 (I-23)

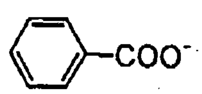 (I-18)

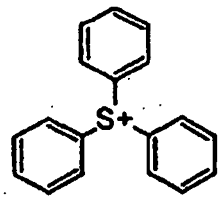

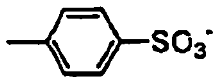 (S-1)

$PF^-_6$ (S-2)

$ClO^-_4$ (S-3)

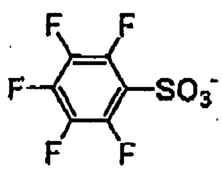 (S-4)

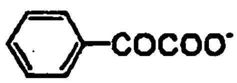 (S-5)

$CF_3SO^{-}3$ (S-6)

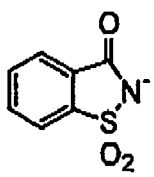 (S-7)

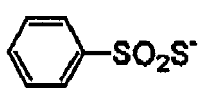 (S-8)

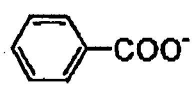 (S-9)

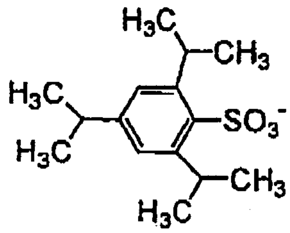

(S-10)

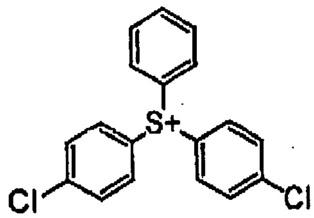

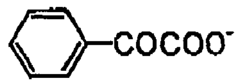

(S-11)

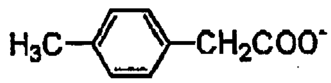

(S-12)

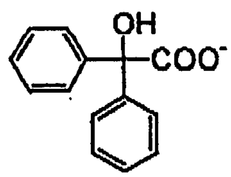

(S-13)

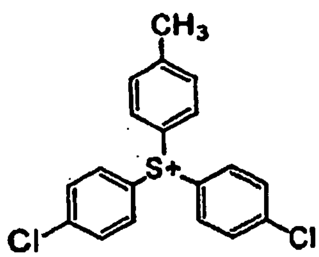

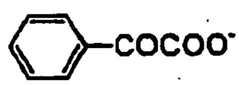

(S-14)

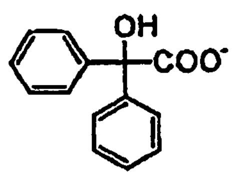

(S-15)

$BF^-_4$ (S-16)

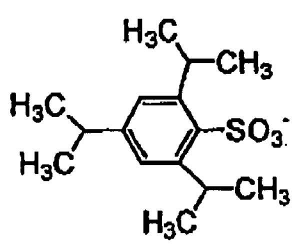

(S-17)

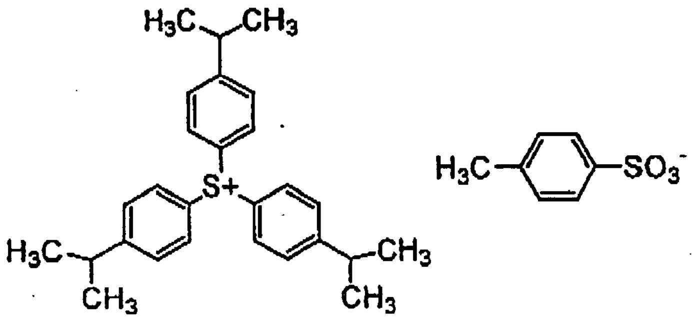

(S-18)

Such a polymerization initiator can be added at a ratio of 0.1 to 50 weight%, preferably from 0.5 to 30 weight%, more preferably from 1 to 20 weight%, based on all solid contents constituting the image recording layer. Within this range, high sensitivity and good antiscumming property of the non-image area at the printing can be obtained. One of these polymerization initiators may be used alone, or two or more thereof may be used in combination. Also, this polymerization initiator may be added together with other components in the same layer or may be added to a layer separately provided.

<Polymerizable Compound>

The polymerizable compound for use in the present invention is an addition-polymerizable compound having at least one ethylenically unsaturated double bond and is preferably a compound having two or more ethylenically unsaturated bonds. In the present invention, in view of the above-described elastic modulus, the polymerizable compound preferably has a low viscosity (coefficient of viscosity) in the vicinity of room temperature. The viscosity at 25°C is preferably 20,000 mPa·s (cP) or less, more preferably 15,000 mPa·s (cP) or less. If the viscosity of the polymerizable compound is too high, the elastic modulus becomes high and attachment of a debris to an ink roller increases.

Such a polymerizable compound is preferably selected from esters of an unsaturated carboxylic acid (e.g., acrylic acid, methacrylic acid, itaconic acid, crotonic acid, isocrotonic acid, maleic acid). Examples of the ester include an ester of an acrylic or methacrylic acid with a polyhydric alcohol compound, and examples of the polyhydric alcohol include an aliphatic polyhydric alcohol, and a hydroxyalkylated or ethylene oxide-modified product of isocyanuric acid.

Specific examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, tetramethylolmethane triacrylate, pentaerythritol diacrylate, pentaerythritol triacrylate, pentaerythritol tetraacrylate, dipentaerythritol diacrylate, dipentaerythritol hexaacrylate, dipentaerythritol hydroxypentaacrylate, sorbitol triacrylate, sorbitol tetraacrylate, sorbitol pentaacrylate, sorbitol hexaacrylate, tris(methacryloyloxymethyl)isocyanurate, tris(acryloyloxyethyl)isocyanurate, tris-(acryloyloxypropyl)isocyanurate and bis(acryloyloxyethyl)-hydroxyethylisocyanurate.

Specific examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythrital hexamethacrylate, sorbitol trimethaerylate, sorbitol tetramethacrylate, bis[p-(3-methacryloxy-2-hydroxypropoxy)phenyl] dimethylmethane, bis[p-(methacryloxyethoxy)phenyl]dimethylmethane, tris (methacryloyloxymethyl) isocyanurate, tris (methacryloyloxyethyl)isocyanurate, tris(methacryloyloxypropyl)isocyanurate and bis(methacryloyloxyethyl)-hydroxyethylisocyanurate.

By using a low-purity polymerizable compound or using two or more polymerizable compounds in combination, the compatibility or dispersibility of the polymerizable compound with other components (e.g., polymer binder, initiator, colorant) in the image recording layer can be enhanced or the viscosity can be adjusted.

The polymerizable compound is preferably used in an amount of 10 to 70 weight%, more preferably from 20 to 60 weight%, based on all solid contents constituting the image recording layer.

<Polymer Binder>

The polymer binder for use in the present invention preferably contains substantially no acid group such as carboxyl group, sulfone group and phosphoric acid group, because this is effective in realizing not only excellent film

strength or film property of the image recording layer but also good solubility or dispersibility in an oily ink as well as enhanced on-press developability. Furthermore, the polymer binder usable in the present invention is preferably a material having high flexibility so as to suppress the elevation of elastic modulus, and a material less undergoing intermolecular or intramolecular interaction and having low orystailinity or glass transition temperature (Tg) is preferably used. In particular, a material with its side chain containing a unit having high flexibility and long molecular chain can have a low Tg and is preferred The polymer binder is selected from copolymers of acrylic acid ester and/or methacrylic acid ester. Among these, preferred are copolymers comprising a monomer unit having a $-CH_2CH_2O-$structure in the R moiety of -COOR in such an ester. Specific examples thereof are set forth below, but the present invention is not limited thereto.

Polymer Binder (1):

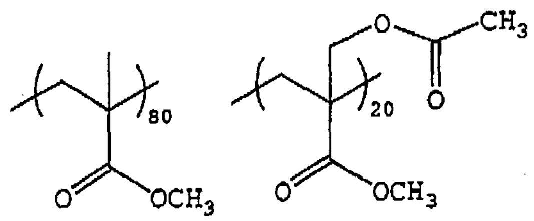

Polymer Binder (2):

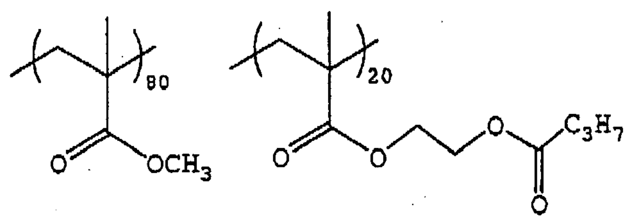

Polymer Binder (3):

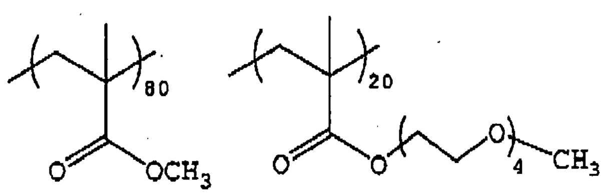

Polymer Binder (4):

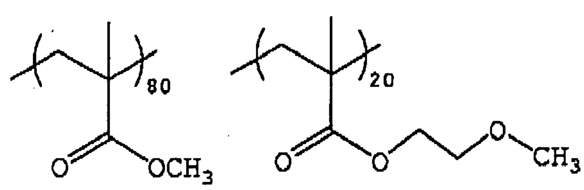

Polymer Binder (5):

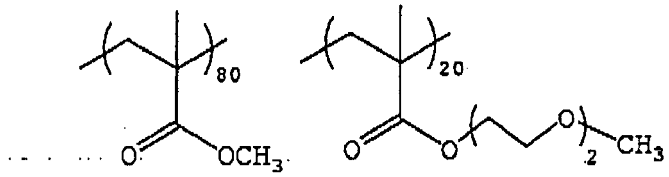

Polymer Binder (6):

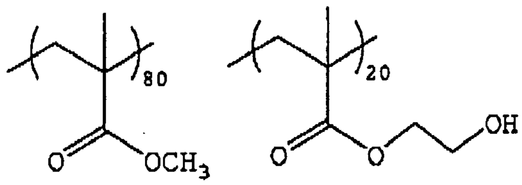

The polymer binder may have a crosslinking property so as to enhance the film strength after exposure. The crosslinking property may be imparted to the polymer binder by introducing a crosslinking functional group such as ethylenically unsaturated bond into the main or side chain of the polymer. The crosslinking functional group may also be introduced by copolymerization. Examples of the polymer having an ethylenically unsaturated bond in the molecular side chain include polymers which are a polymer of acrylic or methacrylic acid ester and in which the ester residue (R in - COOR) has an ethylenically unsaturated bond. Specific examples of the ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein x represents a dicyclopentadienyl residue).

The polymer binder preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The polymer binder may be a random polymer, a block polymer, a graft polymer or the like but is preferably a random polymer.

The polymer binders may be used individually or in combination of two or more thereof.

The content of the polymer binder is from 5 to 70 weight%, preferably from 10 to 50 weight%, more preferably from 10 to 40 weight%, based on the entire solid content of the image recording layer.

The elastic modulus elevates in proportion to the content of the polymer binder in the image recording layer and deposition of a debris on an ink roller increases. Therefore, in the present invention, it is important to adjust the weight ratio of the polymerizable compound to the polymer binder. The weight ratio of the polymerizable compound to the polymer binder is preferably from 1/2 to 7/2, more preferably from 4/5 to 7/2. Within this range, good results can be obtained in terms of the deposition of a debris on an ink roller while causing no adverse effect on the image strength and image forming property.

<Infrared Absorbent>

In the image recording layer of the lithographic printing plate precursor which is imagewise exposed by using a light source of emitting infrared ray, an infrared absorbent may be used in combination with the above-described polymerization initiator. The infrared absorbent has a function of converting the absorbed infrared ray into heat and by the effect of heat generated here, the polymerization initiator thermally decomposes to generate a radical. The infrared absorbent for use in the present invention is a dye or pigment having an absorption maximum at a wavelength of 760 to 1,200 nm.

As for the dye, commercially available dyes and known dyes described in publications such as Senryo Binran (Handbook of Dyes), compiled by Yuki Gosei Kagaku Kyokai (1970) may be used. Specific examples thereof include dyes such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes

described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Among these dyes, preferred are cyanine dyes, squarylium dyes, pyrylium salts, nickel thiolate complexes and indolenine cyanine dyes, more preferred are cyanine dyes and indolenine cyanine dyes, still more preferred is a cyanine dye represented by the following formula (I):

Formula (I):

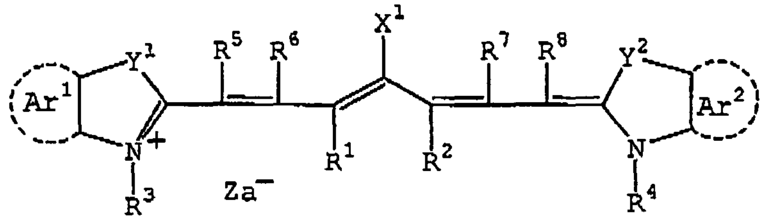

In formula (I), $X^1$ represents a hydrogen atom, a halogen atom, $-NPh_2$, $X^2$-$L^1$ or a group shown below (wherein $X^2$ represents an oxygen atom, a nitrogen atom or a sulfur atom, $L^1$ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), $X_a^-$ has the same definition as Za-described later, and $R^a$ represents a substituent selected from a hydrogen atom, an alkyl group, an aryl group, a substituted or unsubstituted amino group and a halogen atom):

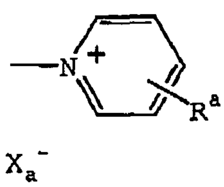

$R^1$ and $R^2$ each independently represents a hydrocarbon group having from 1 to 12 carbon atoms. In view of storage stability of the coating solution for the recording layer, $R^1$ and $R^2$ each is preferably a hydrocarbon group having 2 to more carbon atoms, and $R^1$ and $R^2$ are more preferably combined with each other to form a 5- or 6-membered ring.

$Ar^1$ and $Ar^2$ may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. $Y^1$ and $Y^2$ may be the same or different and each represents a sulfur atom or a dialkylmethylene group having 12 or less carbon atoms. $R^3$ and $R^4$ may be the same or different and each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$ may be the same or different and each represents a hydrogen atom or a hydrocarbon group having 12 or less carbon atoms, and in view of availability of the raw material, preferably a hydrogen atom. $Za^-$ represents a counter anion but when the cyanine dye represented by formula (I) has an anionic substituent in its structure and neutralization of electric charge is not necessary, $Za^-$ is not present. In view of storage stability of the coating solution for the recording layer, $Za^-$ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (I), which can be suitably used in the present invention, include those described in paragraphs [0017] to [0019] of JP-A-2001-133969.

Other preferred examples include specific indolenine cyanine dyes described in JP-A-2002-278057.

As for the pigment used in the present invention, commercially available pigments and pigments described in Color Index (C.I.) Binran (C.I. Handbook), Saishin Ganryo Binran (Handbook of Newest Pigments), compiled by Nippon Ganryo Gijutsu Kyokai (1977), Saishin Ganryo Oyo Gijutsu (Newest Pigment Application Technology), CMC Shuppan (1986) , and Insatsu Ink Gijutsu (Printing Ink Technology), CMC Shuppan (1984) can be used.

The kind of pigment includes black pigment, yellow pigment, orange pigment, brown pigment, red pigment, violet pigment, blue pigment, green pigment, fluorescent pigment, metal powder pigment and polymer bond dye. Specific examples of the pigment which can be used include insoluble azo pigments, azo lake pigments, condensed azo pigments, chelate azo pigments, phthalocyanine-based pigments, anthraquinone-based pigments, perylene- or perynone-based pigments, thioindigo-based pigments, quinacridone-based pigments, dioxazine-based pigments, isoindolinone-based pigments, quinophthalone-based pigments, dyed lake pigments, azine pigments, nitroso pigments, nitro pigments, natural pigments, fluorescent pigments, inorganic pigments and carbon black. Among these pigments, carbon black is preferred.

These pigments may or may not be surface-treated before use. Examples of the method for surface treatment include a method of coating the surface with resin or wax, a method of attaching a surfactant, and a method of bonding a reactive substance (for example, a silane coupling agent, an epoxy compound or an isocyanate) to the pigment surface. These surface-treating methods are described in Kinzoku Sekkan no Seishitsu to Oyo (Properties and Application of Metal Soap), Saiwai Shobo, Insatsu Ink Gijutsu (Printing Ink Technology), CMC Shuppan (1984), and Saishin Ganryo Oyo Gijutsu (Newest Pigment Application Technology), CMC Shuppan (1986).

The particle diameter of the pigment is preferably from 0.01 to 10 μm, more preferably from 0.05 to 1 μm, still more preferably from 0.1 to 1 μm. Within this range, good stability of the pigment dispersion in the coating solution for the image forming layer and good uniformity of the image recording layer can be obtained.

As for the method of dispersing the pigment, known dispersion techniques used in the production of ink or toner may be used. Examples of the dispersing machine include ultrasonic disperser, sand mill, attritor, pearl mill, supermill, ball mill, impeller, disperser, KD mill, colloid mill, dynatron, three-roll mill and pressure kneader. These are described in detail in Saishin Ganryo Oyo Gijutsu (Newest Pigment Application Technology), CMC Shuppan (1986).

The infrared absorbent is preferably added to the image recording layer in a required minimum amount so as to prevent a side reaction of inhibiting the polymerization.

The infrared absorbent can be added at a ratio of 0.001 to 50 weight%, preferably from 0.005 to 30 weight%, more preferably from 0.01 to 10 weight%, based on the entire solid content of the image recording layer. Within this range, high sensitivity can be obtained without causing adverse effect on the uniformity or film strength of the image recording layer.

<Sensitizer>

In the case where the lithographic printing plate precursor is imagewise exposed by using a light source of emitting light at 250 to 420 nm, the radical generation efficiency can be elevated by using a sensitizer in combination with the above-described polymerization initiator in the image recording layer.

Specific examples of the sensitizer include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-tert-butyl-9,10-anthraquinone, 2,6-dichloro-9,10-anthraquinone, xanthone, 2-methylxanthone, 2-methoxyxanthone, thioxanthone, benzyl, dibenzylacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone.

Furthermore, preferred examples of the sensitizer for use in the present invention include compounds represented by formula (II), described in JP-B-51-48516:

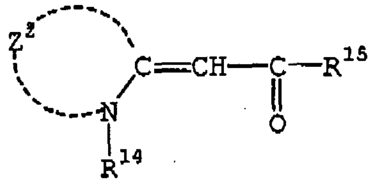

(II)

In formula (II), $R^{14}$ represents an alkyl group (e.g., methyl, ethyl, propyl) or a substituted alkyl group (e.g., 2-hydroxyethyl, 2-methoxyethyl, carboxymethyl, 2-carboxyethyl). $R^{15}$ represents an alkyl group (e.g., methyl, ethyl) or an aryl group (e.g., phenyl, p-hydroxyphenyl, naphthyl, thienyl).

$Z^2$ represents a nonmetallic atom group necessary for forming a nitrogen-containing heterocyclic nucleus

usually used in cyanine dyes, and examples thereof include benzothiazoles (e.g., benzothiazole, 5-chlorobenzothiazole, 6-chlorobenzothiazole), naphthothiazoles (e.g., α-naphthothiazole, β-naphthothiazole), benzoselenazoles (e.g., benzoselenazole, 5-chlorobenzoselenazole, 6-methoxybenzoselenazole), naphthoselenazoles (e.g., α-naphthoselenazole, β-naphthoselenazole), benzoxazoles (e.g., benzoxazole, 5-methylbenzoxazole, 5-phenylbenzoxazole), naphthoxazoles (e.g., α-naphthoxazole, β-naphthoxazole).

Specific examples of the compound represented by formula (II) include those having a chemical structure constituted by combining these $Z^2$, $R^{14}$ and $R^{15}$. Many of such compounds are present as a known substance and therefore, the compound may be appropriately selected and used from those known substances. Other preferred examples of the sensitizer for use in the present invention include merocyanine dyes described in JP-B-5-47095 and ketocoumarin-based compounds represented by the following formula (III):

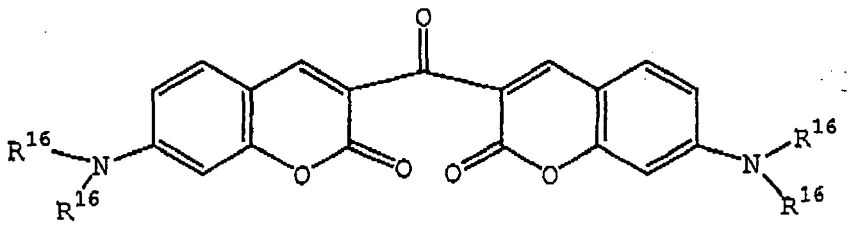

(III)

wherein $R^{16}$ represents an alkyl group such as methyl group and ethyl group.

The sensitizer can be added at a ratio of preferably from 0.1 to 50 weight%, more preferably from 0.5 to 30 weight%, still more preferably from 0.8 to 20 weight%, based on all solid contents constituting the image recording layer.

<Other Components of Image Recording Layer>

The image recording layer of the present invention may further contain various additives, if desired. These are described below.

<Surfactant>

In the present invention, a surfactant is preferably used in the image recording layer so as to accelerate the on-press development at the initiation of printing and enhance the coated surface state. The surfactant includes a nonionic surfactant, an anionic surfactant, a cationic surfactant, an amphoteric surfactant, a fluorine-containing surfactant and the like. The surfactants may be used individually or in combination of two or more thereof.

The nonionic surfactant for use in the present invention is not particularly limited and a conventionally known nonionic surfactant can be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamines, triethanolamine fatty acid esters, trialkylamine oxides, polyethylene glycol, and copolymers of polyethylene glycol and polypropylene glycol.

The anionic surfactant for use in the present invention is not particularly limited and a conventionally known anionic surfactant can be used. Examples thereof include fatty acid salts, abietates, hydroxyalkanesulfonates, alkanesulfonates, dialkylsulfosuccinic ester salts, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated beef tallow oils, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene/maleic anhydride copolymerization products, partially saponified olefin/maleic anhydride copolymerization products and naphthalenesulfonate formalin condensates.

The cationic surfactant for use in the present invention is not particularly limited and a conventionally known cationic surfactant can be used. Examples thereof include alkylamine salts, quaternary ammonium salts, polyoxyethylene alkylamine salts and polyethylene polyamine derivatives.

The amphoteric surfactant for use in the present invention is not particularly limited and a conventionally known amphoteric surfactant can be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene and polyoxybutylene, and these surfactants can also be used in the present invention.

The surfactant is more preferably a fluorine-containing surfactant containing a perfluoroalkyl group within the molecule. This fluorine-containing surfactant includes an anionic type such as perfluoroalkylcarboxylate, perfluoroalkylsulfonate and perfluoroalkylphosphoric ester; an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

The surfactants can be used individually or in combination of two or more thereof.

The surfactant content is preferably from 0.001 to 10 weight% based on the entire solid content of the image recording layer.

<Hydrophilic Polymer>

In the present invention, a hydrophilic polymer may be incorporated so as to enhance the water absorptivity of the image recording layer at the on-press development or enhance the dispersion stability of microcapsules.

Suitable examples of the hydrophilic polymer include those having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, starch derivatives, carboxymethyl cellulose and sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetates having a hydrolysis degree of 60 mol% or more, preferably 80 mol% or more, polyvinyl formal, polyvinyl butyral, polyvinylpyrrolidone, homopolymers and polymers of acrylamide, homopolymers and copolymers of methacrylamide, homopolymers and copolymers of N-methylolacrylamide, polyvinylpyrrolidone, alcohol-soluble nylons, and polyethers of 2,2-bis-(4-hydroxyphenyl)-propane with epichlorohydrin.

The hydrophilic polymer preferably has a weight average molecular weight of 5,000 or more, more preferably from 10,000 to 300,000. The hydrophilic polymer may be a random polymer, a block polymer, a graft polymer or the like.

The content of the hydrophilic polymer in the image recording layer is preferably from 0.5 to 20 weight%, more preferably from 1 to 10 weight%, based on the entire solid content of the image recording layer.

<Colorant>

In the present invention, various compounds may be further added, if desired, in addition to those described above. For example, a dye having large absorption in the visible light region can be used as a colorant for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes described in JP-A-62-293247. Also, pigments such as phthalocyanine-based pigment, azo-based pigment, carbon black and titanium oxide may be suitably used.

The colorant is preferably added, because the image area and the non-image area after image formation can be clearly distinguished. The amount of the colorant added is preferably from 0.01 to 10 weight% based on the entire solid content of the image recording material.

<Printing-Out Agent>

In the image recording layer of the present invention, a compound of undergoing discoloration by the effect of

an acid or a radical can be added so as to produce a print-out image. Various dyes, for example, diphenylmethane-based, triphenylmethane-based, thiazine-based, oxazine-based, xanthene-based, anthraquinone-based, iminoquinone-based and azomethine-based dyes, are effective as such a compound.

Specific examples thereof include dyes such as Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, $\alpha$-Naphthyl Red, Nile Blue 2B, Nile Blue A, Methyl Violet, Malachite Green, Parafuchsine, Victoria Pure Blue BOH [produced by Hodogaya Chemical Co., Ltd.], Oil Blue #603 [produced by Orient Chemical Industry Co., Ltd.], Oil Pink #312 [produced by Orient Chemical Industry Co., Ltd.], Oil Red 5B [produced by Orient Chemical Industry Co., Ltd.], Oil scarlet #308 [produced by orient Chemical Industry Co., Ltd.], oil Red OG [produced by Orient Chemical Industry Co., Ltd.], Oil Red RR [produced by Orient Chemical Industry Co., Ltd.], Oil Green #502 [produced by Orient Chemical Industry Co., Ltd.], Spiron Red BEH Special [produced by Hodogaya Chemical Co., Ltd.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-$\beta$-naphthyl-4-p-diethylaminophenylimino-5-pyrazolone, and leuco dyes such as p,p',p''-hexamethyltriaminotriphenyl methane (Leuco Crystal Violet) and Pergascript Blue SRB (produced by Ciba Geigy).

Other suitable examples include leuco dyes known as a material for heat-sensitive or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(N,N-diethylamino)-5-methyl-7-(N,N-dibenzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.

The dye of undergoing discoloration by the effect of an acid or a radical is preferably added in an amount of 0.01 to 15 weight% based on the solid content of the image recording layer.

<Polymerization Inhibitor>

In the image recording layer of the present invention, a small amount of a thermopolymerization inhibitor is preferably added so as to prevent the polymerizable compound from undergoing unnecessary thermopolymerization during the preparation or storage of the image recording layer.

Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The thermopolymerization inhibitor is preferably added in an amount of about 0.01 to about 5 weight% based on the entire solid content of the image recording layer.

<Higher Fatty Acid Derivative, etc.>

In the image recording layer of the present invention, for example, a higher fatty acid derivative such as behenic acid or behenic acid amide may be added and localized on the surface of the image recording layer during drying after coating so as to prevent polymerization inhibition by oxygen. The amount of the higher fatty acid derivative added is preferably from about 0.1 to about 10 weight% based on the entire solid content of the image recording layer.

<Plasticizer>

The image recording layer of the present invention may contain a plasticizer so as to enhance the on-press developability. Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate; glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate;

polyglycidyl methacrylate, triethyl citrate, glycerin triacetyl ester and butyl laurate.

The plasticizer content is preferably about 30 weight% or less based on the entire solid content of the image recording layer.

<Inorganic Fine Particle>

The image recording layer of the present invention may contain an inorganic fine particle so as to elevate the cured film strength in the image area and enhance the on-press developability of the non-image area.

Suitable examples of the inorganic fine particle include silica, alumina, magnesium oxide, titanium oxide, magnesium carbonate, calcium alginate and a mixture thereof. Even if such an inorganic fine particle has no light-to-heat converting property, the inorganic fine particle can be used, for example, for strengthening the film or roughening the surface to reinforce the interfacial adhesion.

The average particle diameter of the inorganic fine particle is preferably from 5 nm to 10 μm, more preferably from 0.5 to 3 μm. Within this range, the inorganic particles are stably dispersed in the image recording layer, so that the image recording layer can maintain sufficiently high film strength and the non-image area formed can have excellent hydrophilicity to cause less staining at printing.

Such an inorganic fine particle is easily available on the market as a colloidal silica dispersion or the like.

The inorganic fine particle content is preferably 20 weight% or less, more preferably 10 weight% or less, based on the entire solid content of the image recording layer.

<Low-Molecular Hydrophilic Compound>

The image recording layer of the present invention may contain a hydrophilic low-molecular compound so as to enhance the on-press developability. Examples of the hydrophilic low-molecular compound include, as the water-soluble organic compound, glycols and ether or ester derivatives thereof, such as ethylene glycol, diethylene glycol, triethylene glycol, propylene glycol, dipropylene glycol and tripropylene glycol; polyhydraxys such as glycerin and pentaerythritol; organic amines and salts thereof, such as triethanolamine, diethanolamine and monoethanolamine; organic sulfonic acids and salts thereof, such as toluenesulfonic acid and benzenesulfonic acid; organic phosphonic acids and salts thereof, such as phenylphosphonic acid; and organic carboxylic acids and salts thereof, such as tartaric acid, oxalic acid, citric acid, malic acid, lactic acid, gluconic acid and amino acids.

<Formation of Image Recording Layer>

In the present invention, when incorporating the above-described components into the image recording layer, these components may be enclosed, if desired, in a microcapsule and then incorporated. It is also possible to microencapsulate some of the components to be enclosed and incorporate the remaining outside the microcapsule at an arbitrary ratio.

The image recording layer of the present invention preferably contains a microcapsule enclosing at least one of those polymerization initiator (A), polymerizable compound (B) and polymer binder (C). When the image recording layer contains a microcapsule, the on-press developability is enhanced.

For microencapsulating those components, known methods can be used. Examples of the method for producing a microcapsule include, but are not limited to, a method utilizing coacervation described in U.S. Patents 2,800,457 and 2,800,458, a method utilizing interfacial polymerization described in U.S. Patent 3,287,154, JP-B-38-19574 and JP-B-42-446, a method utilizing polymer precipitation described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamineformaldehyde resin and hydroxy cellulose described in U.S. Patent 4,025,445, an *in situ* method utilizing monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has a three-dimensionally crosslinked structure and has .a. property of swelling with a solvent. From this standpoint, the wall material of the microcapsule is preferably polyurea, polyurethane, polyester, polycarbonate, polyamide or a mixture thereof, more preferably polyurea or polyurethane. Also, the above-described compound having a crosslinking functional group such as ethylenically unsaturated bond, which can be introduced into the binder polymer, may be introduced into the microcapsule wall.

The average particle diameter of the microcapsule is preferably from 0.01 to 3.0 μm, more preferably from 0.05 to 2.0 μm, still more preferably from 0.10 to 1.0 μm. Within this range, good resolution and good aging stability can be obtained.

The image recording layer is formed by dispersing or dissolving the above-described necessary components in a solvent to prepare a coating solution and applying the coating solution. Examples of the solvent used here include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyl lactone, toluene and water. These solvents are used individually or in combination. The solid content concentration of the coating solution is preferably from 1 to 50 weight%.

The image recording layer of the present invention may also be formed by dispersing or dissolving the same or different components described above in the same or different solvents to prepare a plurality of coating solutions and repeating the coating and drying multiple times.

The coated amount (solid content) of the image recording layer obtained on the support after coating and drying varies depending on the use but, in general, is preferably from 0.3 to 3.0 $g/m^2$. Within this range, good sensitivity and good film properties of the image recording layer can be obtained.

As for the coating method, various methods may be used and examples thereof include bar coater coating, rotary coating, spray coating, curtain coating, dip coating, air knife coating, blade coating and roll coating.

[Support]

The support for use in the lithographic printing plate precursor of the present invention is not particularly limited and may be sufficient if it is a dimensionally stable plate-like material. Examples of the support include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal. Among these supports, polyester film and aluminum plate are preferred, and aluminum plate is more preferred because this is dimensionally stable and relatively inexpensive.

The aluminum plate is a pure aluminum plate, an alloy plate mainly comprising aluminum and containing trace heteroelements, or an aluminum or aluminum alloy thin film laminated with a plastic. Examples of the heteroelement contained in the aluminum alloy include silicon, iron, manganese, copper, magnesium, chromium, zinc, bismuth, nickel and titanium. The heteroelement content in the alloy is preferably 10 weight% or less. In the present invention, a pure aluminum plate is preferred, but perfectly pure aluminum is difficult to produce in view of refining technique and therefore, an aluminum plate containing trace heteroelements may be used. The aluminum plate is not particularly limited in its composition, and a conventionally known and commonly employed material can be appropriately used.

The thickness of the support is preferably from 0.1 to 0.6 mm, more preferably from 0.15 to 0.4 mm, still more preferably from 0.2 to 0.3 mm.

In advance of using the aluminum plate, the aluminum plate is preferably subjected to a surface treatment such as surface roughening and anodization. By this surface treatment, it is facilitated to enhance hydrophilicity and ensure adhesion between the image recording layer and the support. Before surface-roughening, the aluminum plate is degreased for removing the rolling oil on the surface, if desired, by using a surfactant, an organic solvent, an alkaline aqueous solution or the like.

The surface-roughening treatment of the aluminum plate surface is performed by various methods and examples thereof include a mechanical surface-roughening treatment, an electrochemical surface-roughening treatment (surface-roughening treatment of electrochemically dissolving the surface) and a chemical surface-roughening treatment (surface-roughening treatment of chemically and selectively dissolving the surface).

The mechanical surface-roughening treatment may be performed by using a known method such as ball polishing, brush polishing, blast polishing and buff polishing.

The electrochemical surface-roughening treatment is performed, for example, by a method of passing an alternating or direct current in an electrolytic solution containing an acid such as hydrochloric acid or nitric acid. Also, a method using a mixed acid described in JP-A-54-63902 may be used.

The surface-roughened aluminum plate is, if desired, subjected to an alkali etching treatment using an aqueous solution of potassium hydroxide, sodium hydroxide or the.like and after a neutralization treatment, further subjected to an anodization treatment, if desired, so as to enhance the abrasion resistance.

As for the electrolyte for use in the anodization treatment of the aluminum plate, various electrolytes of forming a porous oxide film may be used. In general, a sulfuric acid, a hydrochloric acid, an oxalic acid, a chromic acid or a mixed acid thereof is used. The electrolyte concentration is appropriately determined according to the kind of the electrolyte.

The anodization treatment conditions vary depending on the electrolyte used and cannot be indiscriminately specified but, in general, the conditions are preferably such that the electrolyte concentration is from 1 to 80 weight%,

the liquid temperature is from 5 to 70°C, the current density is from 5 to 60 A/dm$^2$, the voltage is from 1 to 100 V, and the electrolysis time is from 10 seconds to 5 minutes. The amount of the anodic oxide film formed is preferably from 1.0 to 5.0 g/m$^2$, more preferably from 1.5 to 4.0 g/m$^2$. Within this range, good press life and good scratch resistance in the non-image area of the lithographic printing plate can be obtained.

As for the support used in the invention, the substrate having thereon an anodic oxide film after the above-described surface treatment may be used as-is, but in order to more improve adhesion to the upper layer, hydrophilicity, antiscumming property, heat insulation and the like, treatments described in JP-A-2001-253181 and JP-A-2001-322365, such as treatment for enlarging micropores of the anodic oxide film, treatment for pore-sealing micropores and surface-hydrophilizing treatment of dipping the substrate in an aqueous solution containing a hydrophilic compound, may be appropriately selected and applied. Of course, the enlarging treatment and pore-sealing treatment are not limited to those described in these patent publications and any conventionally known method may be employed. The pore-sealing treatment may be performed, in addition to pore-sealing with steam, by using fluorinated zirconic acid alone, using an aqueous solution containing an inorganic fluorine compound such as sodium fluoride, using steam having added thereto lithium chloride, or using hot water.

Among these, pore-sealing with an aqueous solution containing an inorganic fluorine compound, pore-sealing with water vapor, and pore-sealing with hot water are preferred.

As for the hydrophilization treatment, an alkali metal silicate method described in U.S. Patents 2,714,066, 3,181,461, 3,280,734 and 3,902,734 is known. In this method, the support is dipped in an aqueous solution of sodium silicate or the like, or electrolyzed. Other examples include a method of treating the support with potassium fluorozirconate described in JP-B-36-22063, and a method of treating the support with polyvinylphosphonic acid described in U.S. Patents 3,276,868, 4,153,461 and 4,689,272.

In the case where a support insufficient in the hydrophilicity on the surface, such as polyester film, is used as the support of the present invention, a hydrophilic layer is preferably coated to render the surface hydrophilic. The hydrophilic layer is preferably a hydrophilic layer formed by coating a coating solution containing a colloid of an oxide or hydroxide of at least one element selected from beryllium, magnesium, aluminum, silicon, titanium, boron, germanium, tin, zirconium, iron, vanadium, antimony and transition metals described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation reaction of polyalkoxysilane, titanate, zirconate or aluminate, or a hydrophilic layer comprising an inorganic thin film having a surface containing a metal oxide. Among these, a hydrophilic layer formed by coating a coating solution containing a colloid of an oxide or hydroxide of silicon is more preferred.

In the case of using polyester film or the like as the support of the present invention, an antistatic layer is preferably provided on the hydrophilic layer side or opposite side of the support or on both sides. When an antistatic layer is provided between the support and the hydrophilic layer, this contributes to the enhancement of adhesion to the hydrophilic layer. Examples of the antistatic layer which can be used include a polymer layer having dispersed therein metal oxide fine particle or matting agent described in JP-A-2002-79772.

The support preferably has a center line average roughness of 0.10 to 1.2 μm. Within this range, good adhesion to the image recording layer, good press life and good antisaumming property can be obtained.

The color density of the support is preferably from 0.15 to 0.65 in terms of the reflection density value. Within this range, good image-forming property by virtue of antihalation at the image exposure and good suitability for plate inspection after development can be obtained.

[Undercoat Layer]

In the lithographic printing plate precursor of the present invention, an undercoat layer comprising a compound having a polymerizable group is preferably provided on the support. When the undercoat layer is used, the image recording layer is provided on the undercoat layer. The undercoat layer has an effect of strengthening, in the exposed area, the adhesion between the support and the image recording layer and, in the unexposed part, facilitating the separation of image recording layer from the support, so that the on-press developability can be enhanced.

Specific examples of the undercoat layer which is suitably used include a silane coupling agent having an addition-polymerizable ethylenic double bond reactive group described in JP-A-10-282679, and a phosphorus compound having an ethylenic double bond reactive group described in JP-A-2-304441. Other preferred examples include a compound having a polymerizable group (e.g., methacryl group, allyl group) and a support-adsorbing group (e.g., sulfonic acid group, phosphoric acid group, phosphoric acid ester), and a compound resulting from addition of a hydrophilicity-imparting group (e.g., ethylene oxide group) to the above-described compound.

The coated amount (solid content) of the undercoat layer is preferably from 0.1 to 100 mg/m$^2$, more preferably from 1 to 30 mg/m$^2$.

[Overcoat Layer]

In the lithographic printing plate precursor of the present invention, an overcoat layer dissolvable in a fountain solution may be provided on the image recording layer so as to prevent generation of scratches or the like on the image recording layer, block oxygen or prevent ablation at the exposure with a high-intensity laser.

In the present invention, the exposure is usually performed in air and the overcoat layer prevents low molecular compounds such as oxygen and basic substance present in air, which inhibit an image-forming reaction occurring upon exposure in the image recording layer, from mixing into the image recording layer and thereby prevents the inhibition of image-forming reaction at the exposure in air. Accordingly, the property required of the overcoat layer is low permeability to low molecular compounds such as oxygen. Furthermore, the overcoat layer preferably has good transparency to light used for exposure as well as excellent adhesion to the image recording layer and is easily removable with a fountain solution in the process of on-press development after exposure. Various studies have been heretofore made on the overcoat layer having these properties and such overcoat layers are described in detail, for example, in U.S. patent 3,458,311 and JP-B-55-49729.

Examples of the material used for the overcoat layer include water-soluble polymer compounds having relatively excellent crystallinity. Specific examples thereof include water-soluble polymers such as polyvinyl alcohol, polyvinylpyrrolidone, acidic celluloses, gelatin, gum arabic and polyacrylic acid. In particular, when polyvinyl alcohol (PVA) is used as the main component, most excellent results are obtained with respect to basic properties such as oxygen-blocking property and development removability. A part of the polyvinyl alcohol may be replaced by an ester, an ether or an acetal or may have another oopolymerization component as long as the polyvinyl alcohol contains an unsubstituted vinyl alcohol unit for giving necessary oxygen-blocking property and water solubility to the overcoat layer.

Examples of the polyvinyl alcohol which can be suitably used include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA--210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (for example, selection of PVA and use of additives), coated amount and the like of the overcoat layer are appropriately selected by taking account of fogging, adhesion, scratch resistance and the like in addition to the oxygen-blocking property and development removability. Generally, as the PVA has a higher percentage of hydrolysis (namely, as the unsubstituted vinyl alcohol unit content in the overcoat layer is higher) or as the layer thickness is larger, the oxygen-blocking property is elevated and this is preferred in view of sensitivity. Also, in order to prevent the generation of unnecessary polymerization reaction during production or storage or unnecessary fogging at the image exposure or prevent thickening or the like of the image line, excessively high oxygen permeability is not preferred. Accordingly, the oxygen permeability A at 25°C and 1 atm is preferably $0.2 \leq A \leq 20$ (ml/m$^2$·day).

As for other components of the overcoat layer, glycerin, dipropylene glycol or the like may be added in an amount corresponding to several weight% based on the (co)polymer so as to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether may be added in an amount of several weight% based on the above-described water-soluble polymer compound.

The adhesion to the image area, scratch resistance and the like are also very important in view of handling of the lithographic printing plate precursor. More specifically, when an overcoat layer which is hydrophilic by containing a water-soluble polymer compound is stacked on the image recording layer which is lipophilic, the overcoat layer is readily separated due to insufficient adhesive strength and in the separated portion, defects such as curing failure ascribable to polymerization inhibition by oxygen may be caused.

In order to solve this problem, various proposals have been made with an attempt to improve the adhesive property between the image recording layer and the overcoat layer. For example, JP-A-49-70702 and Unexamined British Patent Publication No. 1,303,578 describe a technique of mixing from 20 to 60 weight% of an acrylic emulsion, a water-insoluble vinylpyrrolidone-vinyl acetate copolymer or the like in a hydrophilic polymer mainly comprising polyvinyl alcohol, and stacking the prepared solution on the image recording layer, thereby obtaining sufficiently high adhesive property. In the present invention, these known techniques all can be used.

Furthermore, other functions may be imparted to the overcoat layer. For example, when a colorant (for example, water-soluble dye) excellent in the transparency to infrared light used for exposure and capable of efficiently absorbing light at other wavelengths is added, the aptitude for safelight can be enhanced without causing decrease in the sensitivity.

The thickness of the overcoat layer is suitably from 0.1 to 5 μm, preferably from 0.2 to 2 μm.

The method for coating the overcoat layer is described in detail, for example, in U.S. Patent 3,458,311 and JP-B-55-49729.[Backcoat Layer]After the support is subjected to a surface treatment or the undercoat layer is formed, a back coat may be provided on the back surface of the support, if desired.

Suitable examples of the backcoat include a coat layer comprising an organic polymer compound described

in JP-A-5-45885 and a coat layer comprising a metal oxide obtained by hydrolyzing and polycondensing an organic or inorganic metal compound described in JP-A-6-35174. Among these, those using an alkoxy compound of silicon, such as $Si(OCH_3)_4$, $Si(OC_2H_5)_4$, $Si(OC_3H_7)_4$ and $Si(OC_4H_9)_4$, are preferred because the raw material is inexpensive and easily available.

[Lithographic Printing Method]

In the lithographic printing method of the present invention, the lithographic printing plate precursor of the present invention is imagewise exposed by exposure through a transparent original having a line image, a halftone image or the like, or by laser scan-exposure based on digital data. Examples of the light source for exposure include a carbon arc lamp, a high-pressure mercury lamp, a xenon lamp, a metal halide lamp, a fluorescent lamp, a tungsten lamp, a halogen lamp, an ultraviolet light laser, a visible light laser and an infrared light laser. In particular, a laser is preferred. Examples of the laser include a solid or semiconductor laser of emitting infrared ray at 760 to 1,200 nm and a semiconductor laser of emitting light at 250 to 420 nm. In the case of using a laser, the imagewise scan-exposure is preferably performed according to digital data. Also, in order to shorten the exposure time, a multi-beam laser device is preferably used.

The exposure time is preferably 20 $\mu$ seconds or less per one picture element. The amount of energy irradiated is preferably from 10 to 300 mJ/cm$^2$.

In the lithographic printing method of the present invention, after imagewise exposure, printing is performed by supplying a printing ink and a fountain solution without passing through any development processing step. Specific examples of the method therefor include a method of exposing the lithographic printing plate precursor with a laser, then loading it on a printing press without passing through a development processing step, and performing printing, and a method of loading the lithographic printing plate precursor on a printing press, exposing it with a laser on the printing press, and performing printing without passing through a development processing step.

When the lithographic printing plate precursor is imagewise exposed with a laser and then printing is performed by supplying a printing ink and a fountain solution without passing through a development processing step such as wet development, the image recording layer cured by the exposure forms a printing ink-receiving part with lipophilic surface in the exposed area of the image recording layer. On the other hand, in the unexposed area, the uncured image recording layer is removed by dissolving or dispersing in the supplied fountain solution or printing ink or in both thereof and the hydrophilic support surface in this portion is revealed.

As a result, the fountain solution adheres to the revealed hydrophilic surface and the printing ink adheres to the image recording layer in the exposed region, thereby initiating the printing. Here, either a fountain solution or a printing ink may be first supplied to the plate surface, but a printing ink is preferably first supplied in view of preventing the fountain solution from contamination by the image recording layer in the unexposed area.

In this way, the lithographic printing plate precursor is on-press developed on an off-set printing press and used as-is for printing a large number of sheets.

## EXAMPLES

The present invention is described in greater detail below by referring to the Examples, but the present invention should not be construed as being limited thereto.

[Examples 1 to 4 and Comparative Examples 1 and 2]

1. Production of Lithographic Printing Plate Precursor

(1) Preparation of Support

A 0.3 mm-thick aluminum plate (construction material: 1050) was degreased with an aqueous 10 weight% sodium aluminate solution at 50˚C for 30 seconds to remove the rolling oil on the surface. Thereafter, the aluminum plate surface was grained by using three nylon brushes implanted with bundled bristles having a diameter of 0.3 mm and a water suspension (specific gravity: 1.1 g/cm$^3$) of pumice having a median diameter of 25 $\mu$m, and then thoroughly washed with water. This plate was etched by dipping it in an aqueous 25 weight% sodium hydroxide solution at 45˚C for 9 seconds and after washing with water, dipped in 20 weight% nitric acid at 60˚C for 20 seconds, followed by washing with water. At this time, the etched amount of the grained surface was about 3 g/m$^2$.

Subsequently, the aluminum plate was subjected to a continuous electrochemical surface-roughening treatment by using AC voltage at 60 Hz. The electrolytic solution used here was an aqueous 1 weight% nitric acid solution (containing 0.5 weight% of aluminum ion) at a liquid temperature of 50˚C. This electrochemical surface-roughening treatment was

performed by using an AC power source of giving a rectangular wave AC having a trapezoidal waveform such that the time TP necessary for the current value to reach the peak from zero was 0.8 msec and the duty ratio was 1:1, and disposing a carbon electrode as the counter electrode. The auxiliary anode was ferrite. The current density was 30 A/$dm^2$ in terms of the peak value of current, and 5% of the current flowing from the power source was split to the auxiliary anode. The quantity of electricity at the nitric acid electrolysis was 175 C/$dm^2$ when the aluminum plate was serving as the anode. Thereafter, the aluminum plate was water-washed by spraying.

Thereafter, the aluminum plate was subjected to an electrochemical surface-roughening treatment in the same manner as in the nitric acid electrolysis above by using, as the electrolytic solution, an aqueous 0.5 weight% hydrochloric acid solution (containing 0.5 weight% of aluminum ion) at a liquid temperature of 50°C under the conditions that the quantity of electricity was 50 C/$dm^2$ when the aluminum plate was serving as the anode, and then water-washed by spraying. This plate was treated in 15 weight% sulfuric acid (containing 0.5 weight% of aluminum ion) as the electrolytic solution at a current density of 15 A/$dm^2$ to provide a DC anodic oxide film of 2.5 g/$m^2$, then washed with water and dried.

The center line average roughness (Ra) of the thus-obtained substrate was measured by using a needle having a diameter of 2 μm and found to be 0.5 μm.

Furthermore, the following Undercoat Solution (1) was coated to have a dry coated amount of 10 mg/$m^2$. In this way, a support for use in the tests later was produced.

Undercoat Solution (1):

| | |
|---|---|
| Undercoat Compound (1) | 0.017 g |
| Methanol | 9.00 g |
| Water | 1.00 g |

Undercoat Compound (1):

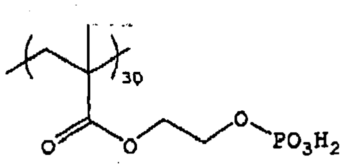
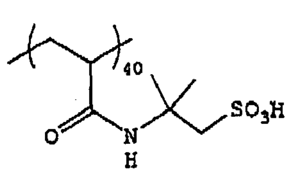
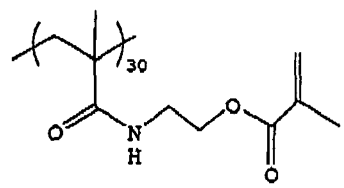

(2) Formation of Image Recording Layer

On the support produced above, the coating solution for image recording layer shown in Table 1 below was bar-coated and then dried in an oven at 100°C for 60 seconds to form an image recording layer having a dry coated amount of 1.0 g/$m^2$, thereby obtaining lithographic printing plate precursors of Examples 1 to 4 and Comparative Examples 1 and 2.

Table 1: Composition of Coating Solution for Image Recording Layer

| | Example | | | | Comparative Example | |
|---|---|---|---|---|---|---|
| | 1 | 2 | 3 | 4 | 1 | 2 |
| Infrared Absorbent (1) shown below | 0.05 | 0.05 | 0.2 | 0.2 | 0.05 | 0.2 |
| Polymerization Initiator (1) shown below | 0.2 | 0.2 | 1.0 | 1.0 | 0.2 | 1.0 |
| Diacryloyloxyethylhydroxyethylisocyanurate (Aronics M-215, produced by Toa Gosei Co., Ltd.) | 1.0 | 1.0 | 3.9 | 3.9 | 1.0 | 3.9 |
| Polymethyl methacrylate (average molecular weight: 80,000) | | | | | 0.5 | 1.6 |
| Polymer Binder (2) | 0.5 | | 1.6 | | | |

(continued)

| | Example | | | | Comparative Example | |
|---|---|---|---|---|---|---|
| | 1 | 2 | 3 | 4 | 1 | 2 |
| Polymer Binder (3) | | 0.5 | | 1.6 | | |
| Naphthalenesulfonate of Victoria Pure Blue | 0.02 | 0.02 | 0.01 | 0.01 | 0.02 | 0.01 |
| Fluorine-Containing Surfactant (1) shown below | 0.1 | 0.1 | 0.8 | 0.8 | 0.1 | 0.8 |
| Microcapsule (1) synthesized below (15 weight% aqueous solution) | | | 26.4 | 26.4 | | 26.4 |
| Methyl ethyl ketone | 18.0 | 18.0 | 10.9 | 10.9 | 18.0 | 10.9 |
| Propylene glycol monomethyl ether | | | 86.1 | 86.1 | | 86.1 |
| Water | | | 24.3 | 24.3 | | 24.3 |

Infrared Absorbent (1):

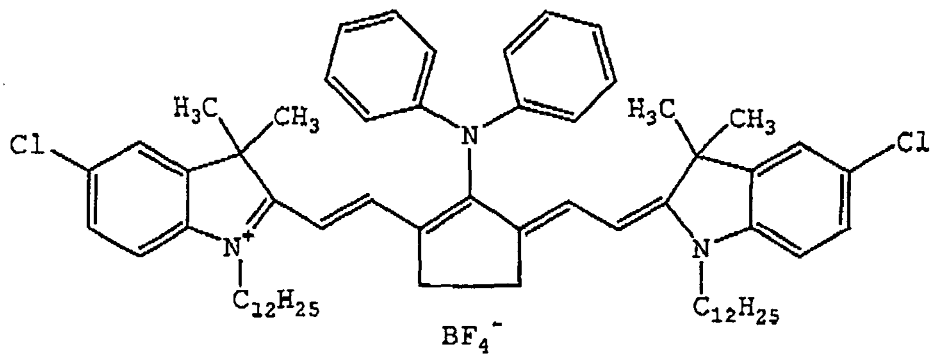

Polymerization Initiator (1):

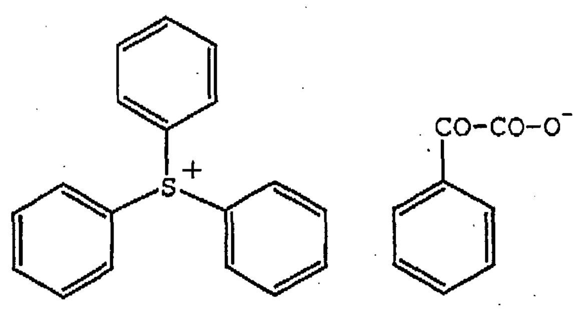

Fluorine-Containing Surfactant (1):

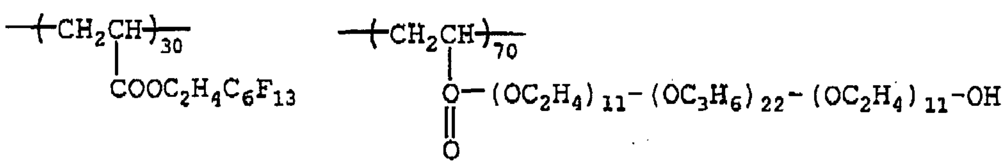

Synthesis of Microcapsule (1):

As the oil phase component, 10 g of trimethylolpropane and xylene diisocyanate adduct (Takenate D-110N, produced by Mitsui Takeda Chemicals, Inc., a 75% ethyl acetate solution), 6.00 g of Aronics M-215 (produced by Toa Gosei Co., Ltd.) and 0.12 g of Pionin A-41C (produced by Takemoto Oil & Fat Co., Ltd.) were dissolved in 16.67 g of ethyl acetate. As the aqueous phase component, 37.5 g of an aqueous 4 weight% PVA-205 solution was prepared. The oil phase component and the aqueous phase component were mixed and emulsified in a homogenizer at 12,000 rpm for 10 minutes. The resulting emulsified product was added to 25 g of distilled water and the mixture was stirred at room temperature for 30 minutes and then stirred at 40°C for 2 hours. The thus-obtained microcapsule solution was diluted with distilled water to a solid content concentration of 15 weight%. The average particle size was 0.2 μm.

Infrared Absorbent (2):

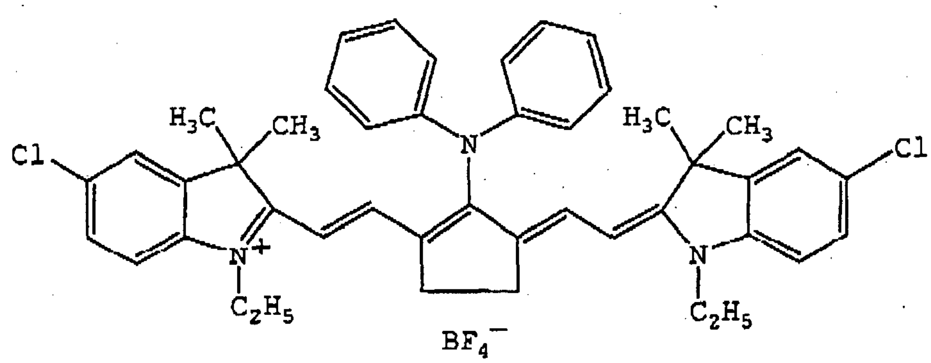

2. Measurement of Elastic Modulus

All materials except for the polymerizable compound and the polymer binder were removed from each coating solution for image recording layer, and 15 g of the resulting solution was spread on a Teflon sheet-made vessel having a bottom area of 25 cm$^2$ and dried at 100°C for 2 hours to remove the solvent component, thereby obtaining a model film for the measurement of elastic modulus. The obtained film was separated from the Teflon sheet and cut out into a size of 10 mm x 50 mm, and the stress-stain curve was measured with a gripping distance of 30 mm (using Tensilon Tester Model UTM-II-20, manufactured by Orientec Corp.). The measurement was performed 5 times and the average thereof was employed. Before the measurement, the thickness, width and length were precisely measured by using a vernier calipers or a micrometer. The elastic modulus is determined from the gradient in the rising linear portion of the stress-strain curve, according to the following formula:

Elastic modulus = [tensile load (g)/cross-sectional area of sample (mm$^2$)]/strain amount

3. Evaluation of Printing

The obtained lithographic printing plate precursors each was exposed by using Trendsetter 3244VX (manufactured by Creo) on which a water-cooling 40 W infrared semiconductor laser was mounted, under the conditions that the output was 9 W, the rotation number of outer drum was 210 rpm and the resolution was 2,400 dpi. Without passing through development processing, the exposed printing plate precursor was loaded on a cylinder of a printing press (SPRINT S26, manufactured by Komori Corp.). Using EU-3 (etching solution, produced by Fuji Photo Film Co., Ltd.)/water/isopropyl alcohol = 1/89/10 (by volume) as a fountain solution and TRANS-G(N) Black Ink (produced by Dai-Nippon Ink & Chemicals, Inc.), a fountain solution and an ink were supplied and thereafter, printing was performed at a printing speed of 8,000 sheets per hour. As a result, on-press development was performed and good printed matters free from staining were obtained.

The printing press was stopped at the 500th sheet and the attached state of removed debris on the ink roller was evaluated according to the following criteria.

Evaluation Criteria for Attached State of Removed Debris:

◎: Debris was not observed on the ink roller at all.
○: Debris was scarcely observed on the ink roller.
△: Debris was slightly observed on the ink roller.
×: Many debris were observed on the ink roller.

Also, the printing plate precursor which was exposed in the same manner was loaded on a cylinder of a printing press (SPRINT S26, manufactured by Komori Corp.). Using EU-3 (etching solution, produced by Fuji Photo Film Co., Ltd.)/water/isopropyl alcohol = 1/89/10 (by volume) as a fountain solution and New Champion F Gloss Medium (transparent ink, produced by Dai-Nippon Ink & Chemicals, Inc.), a fountain solution and an ink were supplied and thereafter, the printing press was rotated 100 turns at a printing speed of 8,000 sheets per hour, thereby performing on-press development.

The printing press was stopped at 100th sheet, the ink on a roller (Q roller) adjacent to the inking roller was sampled and spread on a slide glass, and the dispersion state of the unexposed area of the image recording layer was observed at a magnification of 500 by using a microscope (Digital Microscope VH-6300, manufactured by Keyence Corporation). From the observation range, 10 larger sizes were selected, a largest size was excluded to eliminate a singular point, and the average of maximum widths of remaining 9 sizes was determined. The unexposed area size of the recording layer was expressed by this average value.

The evaluation results are shown together in Table 2.

Table 2: Evaluation Results of Printing

| | Elastic Modulus of Model Film KPa (g/mm$^2$) | Attachment of Removed Image Recording Layer Debris on Ink Roller | Unexposed Area Size of Image Recording Layer in Ink on Ink Roller |
|---|---|---|---|
| Example 1 | 205.9 (21) | ○ | 45 μm |
| Example 2 | 205.9 (21) | ○ | 40 μm |
| Example 3 | 19.6 (2) | ◎ | 20 μm |
| Example 4 | 19.6 (2) | ◎ | 15 μm |
| Comparative Example 1 | 666.9 (68) | × | 90 μm |
| Comparative Example 2 | 666.9 (68) | Δ | 80 μm |

As apparent from Table 2, when the lithographic printing plate precursor of the present invention is used (Examples 1 to 4), excellent results are obtained in terms of attachment of debris on an ink roller as compared with the case of using conventional lithographic printing plate precursors (Comparative Examples 1 and 2).

## Claims

**1.** Lithographic printing plate precursor comprising a support and an image recording layer, which is removable with at least one of a printing ink and a fountain solution, and which comprises

(i) a polymerization initiator,
(ii) at least one addition-polymerizable compound having at least one ethylenically unsaturated double bond, and
(iii) at least one polymer binder selected from copolymers of acrylic esters and/or methacrylic esters,

wherein a film made of the polymerizable compound (ii) and the polymer binder (iii) in the relative amounts as present in the recording layer has an elastic modulus of 294.2 kPa (30 g/mm$^2$) or less.

**2.** The lithographic printing plate precursor of claim 1, wherein the at least one polymerizable compound (ii) has at least two ethylenically unsaturated double bonds.

**3.** The lithographic printing plate precursor of claim 1 or 2, wherein the at least one polymerizable compound (ii) is selected from esters of an unsaturated carboxylic acid.

**4.** The lithographic printing plate precursor of claim 3, wherein the unsaturated carboxylic acid is selected from acrylic acid, methacrylic acid, itaconic acid, crotonic acid, isocrotonic acid and maleic acid.

**5.** The lithographic printing plate precursor of claim 3 or 4, wherein the unsaturated carboxylic acid is esterified with a compound selected from an aliphatic polyhydric alcohol and a hydroxyalkylated or ethylene oxide-modified product of isocyanuric acid.

**6.** The lithographic printing plate precursor of any of the preceding claims, wherein the viscosity of the polymerizable compound (ii) at 25˚C is ≤ 20, 000 mPa·s (cP).

**7.** The lithographic printing plate precursor of any of the preceding claims, wherein the at least one polymer binder (iii) contains substantially no carboxyl groups, sulfone groups and phosphoric acid groups.

**8.** The lithographic printing plate precursor of any of the preceding claims, wherein the at least one polymer binder (iii) is crosslinkable.

**9.** The lithographic printing plate precursor of any of the preceding claims, wherein the image recording layer comprises microcapsules enclosing at least one of the polymerization initiator (i), the polymerizable compound (ii) and the polymer binder (iii).

**10.** The lithographic printing plate precursor of any of the preceding claims, wherein the image recording layer comprises 5-70 wt.-% of polymer binder (iii), based on the solid contents of the image recording layer.

**11.** The lithographic printing plate precursor of claim 1, wherein the weight ratio of polymerizable compound (ii) to polymer binder (iii) contained in the image recording layer is 1:2 to 7:2.

**12.** The lithographic printing plate precursor of claim 11, wherein the weight ratio is 4:5 to 7:2.

**13.** A printing method comprising the steps of:

i) loading the lithographic printing plate precursor comprising a support and an image recording layer as defined in any of claims 1-12 on a printing press;
ii) imagewise exposing the image recording layer with an infrared laser; and
iii) supplying a printing ink and a fountain solution to remove the unexposed portions of the image recording layer from the support.

**Patentansprüche**

**1.** Lithographie-Druckplattenvorläufer umfassend einen Träger und eine Bildaufzeichnungsschicht, die mit wenigstens einem von einer Drucktinte und einem Feuchtmittel entfernbar ist, und die

(i) einen Polymerisationsstarter,
(ii) wenigstens eine Additions-polymerisierbare Verbindung mit wenigstens einer ethylenisch ungesättigten Doppelbindung und
(iii) wenigstens ein polymeres Bindemittel, das ausgewählt ist aus Copolymeren von Acrylsäureestern und/oder Methylacrylsäureestern,

umfaßt, wobei ein aus der polymerisierbaren Verbindung (ii) und dem polymeren Bindemittel (iii) in den relativen Mengen, wie in der Aufzeichnungsschicht vorliegen, hergestellter Film einen Elastizitätsmodul von 294,2 kPa (30 g/mm2) oder weniger aufweist.

**2.** Lithographie-Druckplattenvorläufer gemäß Anspruch 1, wobei die wenigstens eine polymerisierbare Verbindung (ii) wenigstens zwei ethylenisch ungesättigte Doppelbindungen aufweist.

**3.** Lithographie-Druckplattenvorläufer gemäß Anspruch 1 oder 2, wobei die wenigstens eine polymerisierbare Verbindung (ii) ausgewählt ist aus Estern einer ungesättigten Carbonsäure.

4. Lithographie-Druckplattenvorläufer gemäß Anspruch 3, wobei die ungesättigte Carbonsäure ausgewählt ist aus Acrylsäure, Methacrylsäure, Itaconsäure, Crotonsäure, Isocrotonsäure und Maleinsäure.

5. Lithographie-Druckplattenvorläufer gemäß Anspruch 3 oder 4, wobei die ungesättigte Carbonsäure mit einer Verbindung ausgewählt aus einem aliphatischen mehrbasigen Alkohol und einem hydroxyalkylierten oder Ethylenoxid-modifizierten Produkt der Isocyanursäure verestert ist.

6. Lithographie-Druckplattenvorläufer gemäß einem der vorstehenden Ansprüche, wobei die Viskosität der polymerisierbaren Verbindung (ii) bei 25˚C ≤ 20.000 nPa·s (cP) ist.

7. Lithographie-Druckplattenvorläufer gemäß einem der vorstehenden Ansprüche, wobei das wenigstens eine polymere Bindemittel (iii) im wesentlichen keine Carbonsäuregruppen, Sulfongruppen und Phosphorsäuregruppen enthält.

8. Lithographie-Druckplattenvorläufer gemäß einem der vorstehenden Ansprüche, wobei das wenigstens eine polymere Bindemittel (iii) vernetzbar ist.

9. Lithographie-Druckplattenvorläufer gemäß einem der vorstehenden Ansprüche, wobei die Bildaufzeichnungsschicht Mikrokapseln umfaßt, die wenigstens eines von Polymerisationsstarter (i), polymerisierbarer Verbindung (ii) und polymerem Bindemittel (iii) einschließen.

10. Lithographie-Druckplattenvorläufer gemäß einem der vorstehenden Ansprüche, wobei die Bildaufzeichnungsschicht 5 bis 70 Gew.% des polymeren Bindemittels (iii), bezogen auf den Feststoffgehalt der Bildaufzeichnungsschicht, umfaßt.

11. Lithographie-Druckplattenvorläufer gemäß Anspruch 1, wobei das Gewichtsverhältnis der polymerisierbaren Verbindung (ii) zu dem polymeren Bindemittel (iii), die in der Bildaufzeichnungsschicht enthalten sind, 1:2 bis 7:2 beträgt.

12. Lithographie-Druckplattenvorläufer gemäß Anspruch 11, wobei das Gewichtsverhältnis 4:5 bis 7:2 beträgt.

13. Druckverfahren umfassend die Schritte:

i) Einsetzen des Lithographie-Druckplattenvorläufers umfassend einen Träger und eine Bildaufzeichnungsschicht wie in einem der Ansprüche 1 bis 12 definiert in eine Druckmaschine;
ii) bildweises Belichten der Bildaufzeichnungsschicht mit einem Infrarotlaser; und
iii) Zuführen einer Drucktinte und eines Feuchtmittels, um die nicht belichteten Anteile der Bildaufzeichnungsschicht von dem Träger zu entfernen.

## Revendications

1. Précurseur de plaque d'impression lithographique comprenant un support et une couche d'enregistrement d'image, qui peut être enlevée avec au moins l'une parmi une encre d'impression et une solution de mouillage, et qui comprend :

(i) un amorceur de polymérisation,
(ii) au moins un composé polymérisable par addition ayant au moins une double liaison insaturée éthylèniquement, et
(iii) au moins un liant polymère sélectionné parmi des copolymères d'esters acryliques et/ou d'esters méthacryliques,

dans lequel un film constitué du composé polymérisable (ii) et du liant polymère (iii) dans les quantités relatives telles que présentes dans la couche d'enregistrement a un module élastique de 294.2 kPa (30 g/$mm^2$) ou moins.

2. Précurseur de plaque d'impression lithographique selon la revendication 1, dans lequel le au moins un composé polymérisable (ii) a au moins deux doubles liaisons insaturées éthylèniquement.

3. Précurseur de plaque d'impression lithographique selon la revendication 1 ou 2, dans lequel l'au moins un composé

polymérisable (ii) est sélectionné parmi des esters d'un acide carboxylique insaturé.

**4.** Précurseur de plaque d'impression lithographique selon la revendication 3, dans lequel l'acide carboxylique insaturé est sélectionné parmi l'acide acrylique, l'acide méthacrylique, l'acide itaconique, l'acide crotonique, l'acide isocrotonique et l'acide maléique.

**5.** Précurseur de plaque d'impression lithographique selon la revendication 3 ou 4, dans lequel l'acide carboxylique insaturé est estérifié avec un composé sélectionné parmi un alcool polyhydrique aliphatique et un produit de l'acide isocyanurique hydroxyalkylé ou modifié par l'oxyde d'éthylène.

**6.** Précurseur de plaque d'impression lithographique selon l'une quelconque des revendications précédentes, dans lequel la viscosité du composé polymérisable (ii) à 25°C est ≤ 20 000 mPa.s (cP).

**7.** Précurseur de plaque d'impression lithographique selon l'une quelconque des revendications précédentes, dans lequel le au moins un liant polymère (iii) ne contient substantiellement aucun groupe carboxyle, aucun groupe sulfone et aucun groupe acide phosphorique.

**8.** Précurseur de plaque d'impression lithographique selon l'une quelconque des revendications précédentes, dans lequel le au moins un liant polymère (iii) est réticulable.

**9.** Précurseur de plaque d'impression lithographique selon l'une quelconque des revendications précédentes, dans lequel la couche d'enregistrement d'image comprend des microcapsules renfermant au moins l'un parmi l'amorceur de polymérisation (i), le composé polymérisable (ii) et le liant polymère (iii).

**10.** Précurseur de plaque d'impression lithographique selon l'une quelconque des revendications précédentes, dans lequel la couche d'enregistrement d'image comprend 5 à 70 % en poids de liant polymère (iii), sur la base de la teneur en substances solides de la couche d'enregistrement d'image.

**11.** Précurseur de plaque d'impression lithographique selon la revendication 1, dans lequel le rapport en poids du composé polymérisable (ii) au liant polymère (iii) contenu dans la couche d'enregistrement d'image est compris entre 1:2 et 7:2.

**12.** Précurseur de plaque d'impression lithographique selon la revendication 11, dans lequel le rapport en poids est compris entre 4:5 et 7:2.

**13.** Procédé d'impression comprenant les étapes consistant à :

i) charger le précurseur de plaque d'impression lithographique comprenant un support et une couche d'enregistrement d'image, tel que défini dans l'une quelconque des revendications 1 à 12, sur une presse d'impression ;
ii) exposer, à la manière d'une image, la couche d'enregistrement d'image à un laser infrarouge ; et
iii) apporter une encre d'impression et une solution de mouillage pour enlever du support les parties non exposées de la couche d'enregistrement d'image.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2938397 B
- JP 2001277740 A
- JP 2001277742 A
- JP 2002287334 A
- JP 2000039711 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2003328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A

- JP 59084249 A
- JP 59146063 A
- JP 59146061 A
- JP 59216146 A
- US 4283475 A
- JP 5013514 B
- JP 5019702 B
- US 4756993 A
- JP 2001133969 A
- JP 2002278057 A
- JP 51048516 B
- JP 5047095 B
- JP 62170950 A
- JP 62226143 A
- JP 60168144 A
- JP 62293247 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- US 3458311 A
- JP 55049729 B
- JP 49070702 A
- GB 1303578 A
- JP 5045885 A
- JP 6035174 A

**Non-patent literature cited in the description**


- **WAKABAYASHI et al.** *Bull. Chem. Soc. Japan,* 1969, vol. 42, 2924
- **M.P. HUTT.** *Journal of Heterocyclic Chemistry,* 1970, vol. 1 (3
- *J.C.S. Perkin II,* 1979, 1653-1660
- *J.C.S. Perkin II,* 1979, 156-162
- *Journal of Photopolymer Science and Technology,* 1995, 202-232
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh. Proc. Conf. Rad. Curinq ASIA,* October 1988, 478